# EUROPEAN PATENT SPECIFICATION

(11) **EP 2 351 472 B1**
(45) Date of publication and mention of the grant of the patent: **12.09.2012**
(21) Application number: 09744438.4
(22) Date of filing: 28.10.2009
(51) Int. Cl.: H05K 3/24, C25D 5/04, C25D 5/02, H05K 3/18

(54) **IMPROVEMENTS RELATING TO ADDITIVE MANUFACTURING PROCESSES**
VERBESSERUNGEN IN BEZUG AUF ADDITIVE HERSTELLUNGSPROZESSE
PERFECTIONNEMENTS SE RAPPORTANT À DES PROCESSUS DE FABRICATION ADDITIFS

(30) Priority: 30.10.2008 EP 08275066; 30.10.2008 GB 0819911
(43) Date of publication of application: 03.08.2011
(73) Proprietor: BAE Systems PLC, London SW1Y 5AD (GB)
(72) Inventor: SIDHU, Jagit, South Gloucestershire BS34 7QW (GB)
(74) Representative: BAE SYSTEMS plc Group IP Department
(86) International application number: PCT/GB2009/051446
(87) International publication number: WO 2010/049730

(56) References cited:
- EP-A- 1 311 145
- WO-A-99/34036
- GB-A- 2 060 699
- US-A1- 2003 173 225

## Description

### Field of the Invention

This invention concerns improvements relating to additive manufacturing processes.

### Background of the Invention

The term Direct Write is commonly used to describe a range of technologies which allows the fabrication of two or three-dimensional functional structures using processes that are compatible with being carried out directly onto potentially large complex shapes (DTI Report February 2004 "Direct Writing"). Direct Write manufacturing techniques include: Ink jet, Micro-spray, Quill, Pen, Aerosol, Pulsed laser evaporation, and Laser direct etching. Direct Write has the ability to fabricate active and passive functional devices directly onto structural parts and assemblies. The benefits of utilising these techniques are increased functionality, reduced size and weight, reduced cost, design simplification, reduction in component number and a reduction in time to market. In the field of Aerospace, there are applications for Direct Write such as electronic circuits, sensors, RF devices, displays, stealth materials, meta-materials, packaging, sensors and harnesses.

Additive manufacturing is a generic term used to describe a process by which successive layers of a structure, device or mechanism are formed, and in which in each layer components such as electrical circuit components may be formed by a Direct Write method. The term "additive" is used to contrast conventional manufacturing processes such as lithography, milling, turning etc, in which material from a solid layer or object is taken away or removed.

In general, in Direct Write and additive manufacturing processes, writing or printing materials are referred to as inks, although the actual form of the material may comprise a wide range of powders, suspensions, plasters, colloids, solutes, vapours etc, which may be capable of fluid flow and which may be applied in pastes, gels, sprays, aerosols, liquid droplets, liquid flows, etc. Once applied, the material may be fixed by curing, consolidating, sintering or allowing to dry, frequently involving application of heat to change the state of the material to a solid phase. For the purposes of the present specification, the term "Direct Write ink" is intended to cover all such materials.

The object or structure (which may be a very large three-dimensional object) on which the deposition is performed is referred to in the art by the term "substrate", and this is the sense of the term as used in the present specification. The deposited ink, once fixed on the substrate, forms a component or part or layer or precursor of a structure that is to be manufactured.

Recently there has been much interest in direct writing or printing of electronics, sensors and wiring directly onto substrates. The substrates can be virtually any structural or non-structural components or objects or structures. Direct Write can be useful where the substrate is a structural component having a flat surface or having a conformal surface, by which is meant a surface curved in two directions. Direct Write might be particularly suited to the application of printed electronics, sensors and wiring directly onto structural components of a substrate or an object, for example where there was a desire to save weight. Some examples of functional structures which might be applied to such a substrate include antennae and frequency selective surfaces, microwave filters, wires on a surface of a large object such as an aircraft, the inside of the car, inside a helmet or other item of clothing etc.

A factor which tends to limit the application of Direct Write in circumstances where in the current state of the art bulk wire with conventional bulk metal properties is used is the limited conductivity of commonly available printed materials. Generally the electrical conductivity of deposited and fixed Direct Write Ink is much less than that of typical bulk metal wire conductor, and can be as low as a few percent of the bulk metal.

Additionally, current curing methods can limit applicability and practicality of Direct Write. With almost all deposition methods used for Direct Write, after deposition the inks have to be cured, consolidated or sintered. There are inks for which this can be done with optical radiation but for most high performance inks this is done thermally by placing the substrate in an oven. This method has numerous deficiencies:
- Curing temperature for the inks is limited by the substrate operating temperature. Generally the higher the temperature at which the inks are cured, the better the performance. Thus curing at a lower temperature limited by the substrate compromises the ink performance, and limits the range of ink chemistries that can be used.
- There may be other elements on the substrate whose performance would be impaired by the elevated temperature they would be exposed to during a curing cycle.
- If the substrate is large it may not be practical to place it in the oven for curing.
- Invariably, printing requires multiple layers of printing and generally each layer has to be thermally consolidated prior to the deposition of the subsequent layer. If this is done by placing the substrate in the oven after each layer is printed, then there can be problems in registration accuracy when the substrate is tooled for printing. Ensuring accurate registration after each curing step in the oven also requires complex and costly tooling.
- When depositing multiple layers, the removal and subsequent realignment of the substrate for curing in the oven is a costly and time consuming step.

There are a number of prior art methods that enable the depositional application of tracks with bulk metal properties.

For example electroless plating is known in which a seed layer is printed over the area which is to be plated, the coated surfaces then immersed in a metal solution, and metal lines then condense onto the activating layer. By controlling time and temperature the thickness of the coating can be controlled, and thick coatings (tens of microns or more) can be grown which approximate more to bulk metal properties. The technique is generally considered to be incompatible with Direct Write as the fine control of temperature and immersion time required for good uniform coatings imposes a requirement that the component plus seed layer be immersed in a bath of solution. This is not compatible with printing directly onto large structural substrates.

Electroplating may similarly involve the coating of the surface with an initial seed layer. The substrate is then immersed in a metal solution, a current is passed through the seed layer, and metal lines from the solution condense onto the seed layer. Again, it is usual to require a bath. Again, therefore, the technique offers limited compatibility to Direct Write.

Neither technique is practical in relation to conformal substrates with complex surface geometries.

Electroplating methods which do not involve a bath are known. For example, in brush electroplating, localized areas or entire items are plated using a brush saturated with plating solution. A refinement of a localized bathless electroplating method is described in WO99/52336 and WO2004/07320. The effectiveness of such a method may depend on the provision of a suitable deposition surface.

US 2003/173225 A1 discloses a method and an apparatus comprising the features of the prior-art portions of claims 1 and 7.

The present invention aims to overcome or at least substantially reduce some or all of the above discussed drawbacks.

### Summary of the Invention

The invention combines principles of Direct Write techniques or other techniques offering comparable flexibility in applying patterns to the surfaces of conformal objects and principles of electroplating to lay down functional materials on a substrate that approximate better than conventional Direct Write materials to bulk metal conductivity, but that overcome the need in an electroplating process of placing a substrate in a bath, and preferably further the need in a Direct Write process of placing a substrate in an oven.

A suitable surface preparation step is carried cut to create an at least partially conducting patterned area in an appropriate pattern on a substrate surface. For example, a surface layer material such as a Direct Write ink is applied to form an at least partially conducting patterned area in an appropriate pattern. This serves as an initial layer which may be of limited conductivity, but is sufficiently conductive to act as a seed layer for electroplating of a conductor. The conductor is plated in situ in a bathless process. For example the conductor is plated in situ as part of a continuous process immediately subsequent to the Direct Write printing and fixing of the initial layer.

In a first aspect, the present invention provides a method of forming a component of a conductive structure on a substrate, comprising: in a first step applying a surface treatment to said substrate to form a patterned area having at least some electrical conductivity; in a second step electroplating onto the patterned area by means of a tool comprising a first electrode and an electrolyte source for in situ supply of electrolyte, by providing an anode current to the first electrode, causing the patterned area at least in the vicinity of the tool to function as a cathode, and passing electrolyte between said patterned area and said first electrode, thereby to deposit conductive material onto said patterned area.

The steps of applying the surface treatment to the substrate and plating the conductor are performed closely consecutively in a continuous progressive process, so that a pattern of areas of seed conductivity is created on a surface of a substrate, for example in the preferred embodiment in that a secondarily fixable material such as a curable composition is applied onto and fixed onto a surface of a substrate, and a conductor is then deposited onto a substrate in a continuous manner.

In one possible embodiment of the first step of applying a surface treatment, selected areas of the surface of said substrate defining the patterned area are subjected to a physical treatment that modifies the conductive properties of the substrate itself, for example by application of an external energy source such as a light source to selected areas of the surface of the substrate. In this manner, selected areas of the substrate itself have modified conductive properties sufficiently conductive to act as a seed layer for electroplating of a conductor in the second step.

In another possible embodiment of the first step of applying a surface treatment, a surface layer material is applied to selected areas of the surface of said substrate defining the patterned area to create a patterned area having at least some electrical conductivity. The surface layer material is at least sufficiently conductive to act as a seed layer for electroplating of a conductor in the second step. The surface layer material may conveniently comprise a material adapted to be applied in fluid form (for example as a liquid, colloid, solution or other flowable composition) and secondarily treated to form a consistent and for example solid conductive layer. The first step of the method thus comprises applying such a fluid material to selected areas of the surface of the substrate and secondarily treating the fluid material to fix it in situ thereon. The surface layer material is for example a curable composition, and the first step of the method comprises applying a curable composition to selected areas of the surface and curing the same in situ thereon.

Conveniently in this embodiment the curable composition is a Direct Write ink and the method comprises in a first step applying a Direct Write ink onto a predetermined region of said substrate to form a patterned area having at least some electrical conductivity; and subsequently fixing said Direct Write ink; and in a second step electroplating onto the fixed Direct Write ink by means of a tool comprising a first electrode and an electrolyte source for in situ supply of electrolyte, by providing an anode current to the first electrode, causing the patterned area at least in the vicinity of the tool to function as a cathode, and passing electrolyte between said patterned area and said first electrode, thereby to deposit conductive material onto said patterned area.

The fluid material may be secondarily treated and fixed in any known manner, and for example may be a curable material to be cured thermally, via a photocure, a chemical cure or otherwise. The fluid material may be secondarily treated for example via a batch or continuous method.

Preferably, the secondary treatment step of fixing the fluid material comprises a step of secondarily treating the fluid material and for example curing a curable composition in situ via a continuous method, for example by means of a drying process, a thermal cure, a photocure, a chemical cure etc in familiar manner.

Preferably, the step of secondarily treating the fluid material and for example curing the curable composition is performed closely consecutively to the step of applying the fluid material or curable composition in a continuous progressive process, so that a pattern of a fluid material/ curable composition is applied onto and fixed in situ on a predetermined region of the substrate in a continuous manner.

Particularly preferably the fluid material is a curable composition requiring an input energy for cure, for example to effect a thermal cure or photocure, and the step of curing the curable composition comprises positioning a means to supply a curing energy to the region having the curable composition applied and operating the same to input energy to the region in order to fix the curable composition.

Particularly preferably the means to supply a curing energy is adapted to supply a curing energy in localised manner to a local portion of a region having the curable composition applied, most preferably to a local portion closely successively behind a printing site so that a pattern of a curable composition may be applied onto and cured in situ on a substrate in a progressive continuous manner.

For example the means to supply a curing energy is a heating means and the step of curing the curable composition comprises positioning such heating means remotely spaced from but adjacent to the region having the curable composition applied and operating to apply heat to the region in order to cure the curable composition. Preferably, the heating means is configured to focus the heating effect to the region having the curable composition applied.

For example, the heating means is an inductive heating means and the step of curing the curable composition comprises positioning such inductive heating means adjacent to said region having said curable composition applied, and passing an electrical current through said inductive heating means such as to heat said region by electromagnetic inductive effects, in order to cure the curable composition. Particularly preferably the height of the inductive heating means above the curable composition as applied is controlled in such manner as to control the amount of magnetic flux applied to the substrate.

Alternatively for example, the means to supply a curing energy is an electromagnetic radiation source and the step of curing the curable composition comprises positioning such radiation source remotely spaced from but adjacent to said region having said curable composition applied, and operating the radiation source such as to expose said region to incident radiation in order to photocure the curable composition. Conveniently the radiation source is a light source for example of visible or ultraviolet light. A focused source, and for example a laser, is preferably used.

Preferably a fluid material ink is applied onto a predetermined region of said substrate in the form of a line or at least one line. Particularly preferably in this case the fluid material is a curable composition and the step of curing the curable composition comprises positioning an inductive heating means adjacent to said region having said curable composition applied, and passing an electric current through said inductive heating means such as to heat said region by electromagnetic inductive effects, in order to fix said curable composition, wherein the magnetic flux produced by said inductive heating means has an effective diameter at the substrate generally equal to the width of a said line.

Preferably in carrying out the plating step of a method in accordance with the invention, use is made of a plating tool which comprises electrolyte holding means to hold a locally isolated supply of electrolyte, for example comprising an absorptive member in which electrolyte can be carried, in which the means to supply an anode current is an electrode in electrical connection with electrolyte carried by the electrolyte holding means, and in which a coating of electrolyte is applied to the substrate by bringing the electrolyte holding means into function association with the patterned area, and for example into contact with the patterned area.

In one possible embodiment, a means to cause the patterned area at least in the vicinity of the tool to function as a cathode is a second electrode, electrically insulated from the first electrode and spaced from the electrolyte holding means, and the method comprises bringing the second electrode into contact with the patterned area spaced from but simultaneously with bringing the electrolyte holding means into functional association with, and in the preferred case bringing the absorptive member into contact with the patterned area.

In an alternative possible embodiment the patterned area may be treated with a scanning electron beam to ionise the patterned and create an opposite polarity to the polarity of the first electrode.

In a further aspect, the present invention provides an apparatus for forming a component on a substrate, comprising: a surface treatment tool adapted to treat the surface of said substrate for example in the form of a line or at least one line to form a patterned area having at least some electrical conductivity; and an electroplating tool comprising a first electrode and a current supply for providing an anode current to the first electrode, a means to cause the patterned area at least in the vicinity of the electroplating means to function as a cathode, and an electrolyte source for in situ supply of electrolyte between said patterned area and said first electrode, thereby to deposit conductive material onto said patterned area.

The surface treatment tool and the electroplating tool are so disposed on a common apparatus as to be movable across the substrate surface such that the surface treatment tool and the electroplating tool are brought in use consecutively in close succession into functional contact (that is, either into actual contact or into sufficiently close proximity to achieve the desired effect as above described) with the surface.

In one possible embodiment the surface treatment tool is adapted to apply a physical treatment that modifies the conductive properties of the substrate itself, for example comprising an external energy source such as a light source directable to act upon selected areas of the surface of the substrate.

In another possible embodiment the surface treatment tool may comprise a source of a surface layer material as above described adapted to enable the surface layer material to be applied in use to selected areas of the surface of said substrate defining the patterned area to create a patterned area having at least some electrical conductivity.

The surface layer material may conveniently comprise a fluid material adapted to be applied in fluid form and secondarily treated to form a consistent and for example solid conductive layer. The surface layer material is for example a curable composition such as a Direct Write ink composition. The surface treatment tool preferably comprises a printer including fluid material/curable composition deposition means for applying a fluid material/ curable composition onto a region of a substrate for example in the form of a line or at least one line to form a patterned area having at least some electrical conductivity; electroplating means comprising a first electrode and a current supply for providing an anode current to the first electrode, a means to cause the patterned area at least in the vicinity of the electroplating means to function as a cathode, and an electrolyte source for in situ supply of electrolyte between said patterned area and said first electrode, thereby to deposit conductive material onto said patterned area.

Preferably the printer further comprises fixing means to fix fluid material/curing means to cure curable composition deposited on a substrate. Preferably in particular the fixing means comprises a means to fix surface layer material deposited on a substrate in situ. Preferably in particular the fixing means comprises a means positioned to fix surface layer material immediately subsequently to deposition on a substrate to allow print and fix on a predetermined region of the substrate in a progressively continuous manner.

In a preferred embodiment the surface layer material is a curable composition requiring an input energy for cure, for example to effect a thermal cure or photocure, and the fixing means comprises a means supply a curing energy to the region having the curable composition applied to cure the same.

Particularly preferably the means to supply a curing energy is adapted to supply a curing energy in localised manner to a local portion of a region having the curable composition applied, most preferably to a local portion closely successively behind a printing site so that a pattern of a curable composition may be applied onto and cured in situ on a substrate in a progressive continuous manner.

For example the means to supply a curing energy is mounted in spaced relationship with the curable material deposition means, conveniently on a common Direct Write head, so that the curable material deposition means and the means to supply a curing energy may be brought into successive functional contact with a substrate in use to deposit cured material onto the substrate in a progressively continuous manner.

In a preferred embodiment the fixing means comprises a means to heat curable material in said region in situ and cure the same. For example the fixing means comprises inductive heating means for positioning adjacent said region such as to heat said region by electromagnetic inductive effects as above described. Alternatively the fixing means comprises an electromagnetic radiation source for use with a radiation cured curable material, and for example an optically cured curable material, for positioning adjacent said region such as to expose said region to curing radiation. A radiation source is for example a light source, and is for example a source of optical or uv light. A radiation source preferably provided focused radiation, and is for example a laser source.

Preferably the electroplating tool comprises a means adapted to electroplate conductor onto areas of seed conductivity immediately subsequently to those areas being formed by the surface treatment tool allow creation of a seed layer and subsequent plating of conductor on the substrate in a continuous manner. For example the electroplating tool is juxtaposed in close association behind the surface treatment tool is a use direction to be so adapted.

Preferably the electroplating tool includes an electrolyte source to hold a locally isolated supply of electrolyte in which electrolyte can be carried, an electrode in electrical connection with electrolyte carried by the electrolyte source and adapted for connection with a means to supply an anode current , and a means to bring the electrolyte source into selective functional association to effect plating, for example by contact, with the patterned area.

Preferably the means to hold a locally isolated supply of electrolyte and provide an electrolyte source comprises an absorptive member in which electrolyte can be carried. Conveniently the absorptive member is a brush that can be wiped across the surface of the substrate to coat electrolyte onto the patterned area. Conveniently the absorptive member comprises a flexible foam material having interconnecting pores.

Conveniently the tool may additionally comprise an electrolyte supply to feed a supply of electrolyte to electrolyte source.

In one possible embodiment, a means to cause the patterned area at least in the vicinity of the tool to function as a cathode is a second electrode, electrically insulated from the first electrode and spaced from the electrolyte source, the electroplating means includes means to bring the second electrode into selective contact with the patterned area. In a refinement of this embodiment the second electrode may comprise two electrically connected second electrodes mounted on opposite sides of the electrolyte source such that as the electrolyte source progressively contacts the surface of a substrate in use one of the second electrodes leads the electrolyte source and the other second electrode, trails the electrolyte source.

In an alternative possible embodiment a means to cause the patterned area at least in the vicinity of the tool to function as a cathode comprises a scanning electron beam source to ionise the patterned area in the vicinity of the beam and create an opposite polarity to the polarity of the first electrode.

Means may be provided to focus the electron beam by tuning of voltages applied within an electron gun; and/ or to spread the electron beam by tuning of voltages applied within an electron gun; and/ or to vary the position of the electron beam at the target; and/ or to direct a plurality of electron beams to one or more regions of the target; and for example to direct at least two electron beams which are on opposite sides of the target.

The electron beam source may conveniently be co-located with an anode as above described in an electroplating tool.

The invention relies upon the combination of a surface preparation processes, such as Direct Write ink printing process or other processes to create controlled patterned areas typically of relatively low conductivity, to print an initial strike layer for the electroplating process, and the use of a localised electroplating process to print conductor, and for example metal, to a sufficient thickness to have properties which approximate to bulk properties, onto this strike layer. The layer initially applied to or created on the surface does not need to have a high electrical conduction, and that offered by typical Direct Write inks for example is sufficient. The bulk properties of the fabricated functional material are provided in large part by the electroplated layer.

In this way it is found that a conductive layer may be deposited consistently and accurately to what amounts to a sufficient thickness to approximate to bulk metal conduction properties. However, deposition takes place via an additive process based on Direct Write or other controllable surface patterning process which allows both the surface to be prepared and the subsequent conductive layer to be deposited in situ on a substrate surface without requiring the substrate to be transferred to a curing oven or electroplating bath. Thus, the method and apparatus of the invention are applicable to the direct printing of conductors in substitution for electrical wires, or of the direct in situ fabrication of electronic devices and elements, in a desired position on a large structural object.

In accordance with the preferred embodiment of the invention, a curable composition is fixed in situ by provision of a fixing means for example comprising a curing energy source spaced from but able to impart curing energy to a region in which the ink has been applied. For example, a localised heating source such as an induction coil as above described, or a localised photocure source such as a laser is used.

The curing of a curable composition applied to a conformal surface by means of such a curing tool permits localisation of the energy input to the region in which ink has been applied, but since the tool is spaced from the substrate, the tool may follow the non-linear shape of the surface. The use of an electroplating method which relies upon the fixed curable composition such as Direct Write Ink on such a conformal surface, with its limited conductivity, to serve as a seed layer in conjunction with the first electrode, and lays down the primary conducting material by an electroplating process similarly conveniently involves the movement of an electroplating head in close proximity to, but spaced from the substrate, so that the electroplating head may similarly follow the non-linear shape of the surface.

Whilst it is a clear requirement of the method of the invention that the surface treatment is first applied to the substrate surface and for example the surface layer material is deposited thereon and fixed in situ before the bulk conductor is applied by bringing the electroplating means into proximity thereto, it is an advantage of the method of the present invention that the steps may be performed closely successively. Thus, in accordance with the preferred embodiment of the method of the invention the method comprises the performance of the steps of the method closely successively on a given region of substrate. Conveniently, each is performed as a continuous process progressively across a substrate until a desired component has been formed. Similarly in the case where the surface treatment tool comprises a printer including fluid surface layer material deposition means and fluid surface layer material fixing means, the deposition means, fixing means and electroplating tool are so disposed on a common apparatus as to be movable across the substrate surface such that the deposition means, fixing means and the electroplating tool are brought consecutively in close succession into functional contact with the surface.

In a particularly convenient embodiment of the apparatus of the invention, a combined working head is provided, for example as part of a suitable machine which may move the working head in a desired pattern across the surface of a substrate, including, disposed for successive functional contact with the surface of the substrate, a surface treatment tool such as a printer comprising deposition means and fixing means, and an electroplating means as above described.

In accordance with the invention it is not necessary to immerse the substrate carrying the surface treated patterned areas into a plating bath. Instead, a plating tool is used which brings only a small and localised quantity of electrolyte into contact with the substrate. The method can to some extent be regarded as a substantially dry electroplating method. It is possible to electroplate functional materials with a range of complex and disconnected shapes and properties on a conformal substrate in a manner which would not be practical by an immersion system. It is possible to plate discrete and separate components on a single substrate. For example, using the method or apparatus of the invention, it is possible, via a localised process based on Direct Write or other similarly controllable surface preparation treatment, to provide a variety of electronics, sensors and wiring directly onto substrates having difficult conformal surfaces.

The properties of the conductive layer, and in particular the thickness of the conductive layer, can be closely controlled. The thickness of the conductive layer is essentially determined by the current/ time profile for the third, electroplating step. Functional structures of a range of desired thicknesses can be built up on an initial surface, and in particular structures can be built which have a sufficient thickness to approximate to the properties of more conventionally fabricated bulk metal components.

The components formed by the process may typically be tracks or lines, which are long in relation to their width and height above the substrate. Such tracks or lines may form electrical interconnects, electrical resistive or reactive components, or passive components such as filters. Where areas of deposited ink are required, for example rectangular capacitance pads, these may be formed by deposition of a large number of parallel lines, closely spaced or touching one another. Alternatively, the lines may be distributed over a surface in such a way as to give the surface desired electromagnetic reflective and absorbent characteristics.

In general, the width of tracks formed the process depend on various factors, including inherent ink and substrate characteristics such as viscosity, surface writing temperature, as well as the process parameters of pressure, nozzle size, tip to substrate offset and processing speed.

In practice, the width of the tracks may be less than about 5 mm, for example between 3 and 5 mm. However the width may be decreased to any desired value, depending mainly on the nozzle diameter and the distance of the nozzle from the substrate. Currently a minimum width of about 50 µm may be envisaged.

Conductive tracks may be built up from a series of parallel tracks of much smaller width. For example, a 5 mm wide track may be formed from 5 narrow tracks 900 mm wide.

The fixing of the curable composition is performed in a possible embodiment using an induction coil through which an oscillating current is passed. The coil is placed above the region to be cured. The oscillating current induces charge movement (eddy currents) in the region to be cured and the resistance to this charge movement causes Joule heating in the affected area and thus curing and sintering the inks. The current required for curing will depend on the dimensions of the area to be cured and its electrical and thermal properties, and will thus vary depending on the specifics of the application. A problem with other curing methods that may use localised radiation (such as laser or lamp radiation) is that it is difficult to ascertain when curing has been completed or indeed what the state of the inks being cured is. An additional advantage of this preferred embodiment is that there may be a degree of self control and inherent process monitoring; as the curing progresses the resistance of the inks decreases and thus the rate of curing may decrease. This effect may be monitored and curing automatically adjusted as the curing progresses.

The width of a track of curable composition deposited is a key parameter in determining the dimension of an induction coil for heating the track, since the magnetic flux generated should preferably cover the whole width of the track. Equally a coil which produces substantial flux outside the width of the track will be wasteful of energy and may interfere with neighbouring structures.

Therefore it is preferred to provide an induction coil of small diameter, comparable to track width. If tracks are formed as a series of parallel lines, the coil may have a diameter comparable to the width of an individual line. In a preferred arrangement, a cylindrical coil is vertically disposed above a track so as to produce a strong flux density at its end adjacent the track. The coil may be formed in a U shape so that both ends are positioned adjacent the track. Flux focussing elements such as ferromagnetic core elements may be employed. However any shape or configuration of coil may be used as desired, e.g. toroidal, flat.

The spacing of the coil above the track is also recognised to be a key factor, and a spacing of less than about 50 µm is desirable. As preferred, a capacitance bridge is employed to sense the spacing.

The amount of heating produced in the track will depend on the electrical resistance of the ink. Typically inks will have an initial resistance >100s Ω/m, but as curing takes place this will decrease, and with suitable curing conditions this can be reduced to <1 Ω/m. The track dimensions (height, width) of the deposited ink will also have a direct effect on resistance. For electrical interconnects, a resistance of 3.5 Ω/m is typical.

The fixing of the curable composition is performed in an alternative possible embodiment using a radiation source such as a laser source from which a beam is directed towards a region to be cured. The radiation source is placed above the region to be cured. Radiation such as optical radiation is generated. The frequency and intensity of radiation for curing will depend on the dimensions of the area to be cured and on its particular optical cure properties, and will thus vary depending on the specifics of the application. Suitable combinations of radiation curable ink and radiation source will be familiar to the skilled person.

A surface layer material in accordance with the invention need not have high electrical conductivity, but needs to be sufficiently conductive to serve as a strike layer for the subsequent electroplating step. The surface layer material is thus preferably a conductive ink, for example comprising a curable polymer composition loaded with electrically conductive particles. The polymer may be for example radiation curable, and for example photocurable, or may be thermally curable or otherwise curable or fixable.

The electrolyte comprises a plating solution for laying down a conductive layer of conductive material, and in particular a layer of conductive metallic material in such manner as to approximate to bulk metal properties. The electrolyte is conveniently any suitable metal salt or like composition from which such a metallic conductor layer can be deposited onto the patterned prepared surface as above described. Suitable salts will be familiar.

The above and further features of the present invention are set forth in the appended claims and together with advantages thereof, will become clearer from consideration of the following detailed description of an exemplary embodiment of the invention given with reference to the accompanying drawings.

### Brief Description of the Drawings

Figure 1 is a schematic diagram of a combination head for a Direct Write process incorporating a Direct Write head, an inductive heating coil curing tool, and plating head according to an embodiment of the invention; and
Figure 2 is a schematic diagram showing the inductive heating means of figure 1.

### Detailed Description of the preferred embodiment

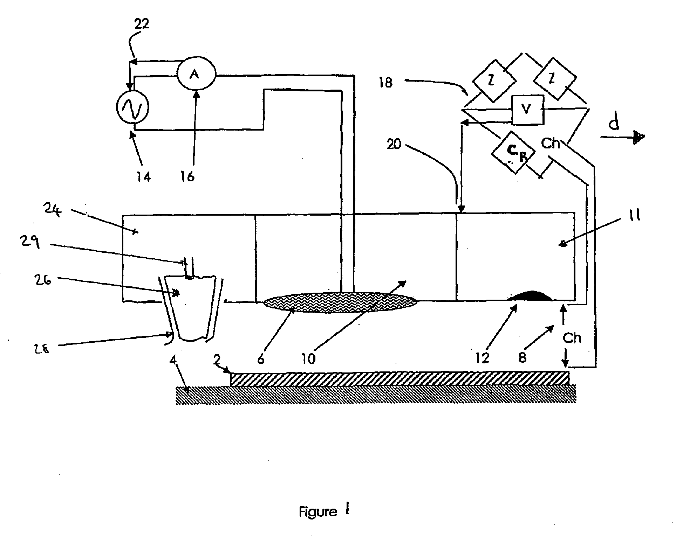

Referring to Figure 1, there is shown a schematic diagram of a combination working head for a Direct Write process according to the principles of the invention incorporating a Direct Write head with an inductive heating coil and a plating head. Thus, in the embodiment, an initial surface preparation treatment to create a limited conductivity strike surface for subsequent plating is via deposition of a Direct Write ink, It will be appreciated that an initial surface preparation involving other deposited curable or other surface layer materials, or direct modification of the surface itself, for example by exposure to light, will be within the scope of the invention.

In the embodiment of Figure 1 a working head 10 of a deposition mechanism in accordance with the invention includes a Direct Write portion 11 having a nozzle 12 for emitting a Direct Write ink (which could be in the form of a vapour, particles, jet, or a liquid extrusion). The Direct Write ink is deposited as a track 2 on the substrate 4. The Direct Write ink forms a layer of fixable material which in the embodiment is susceptible to a thermal cure. For example the track comprises a thermally curable polymer. The Direct Write ink is to some extent electrically conductive, and for example comprises a thermally curable polymer having inherently conductive properties and/ or loaded with conductive particles.

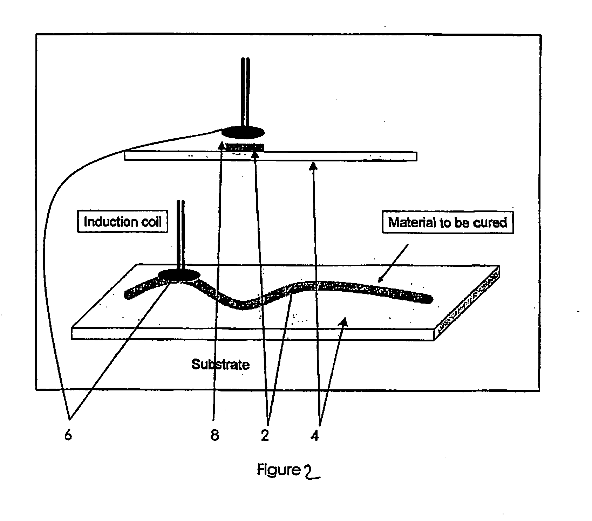

Thermal cure is effected locally by means of induction heating means, removing the need to place the object in a curing tank or oven. An induction coil 6 is formed as a flat coil in a printed circuit, and is affixed to the underside of the head. A source of alternating current 14 is coupled to the coil 6, and an ammeter 16 is used to monitor the current through the coil 6. As shown, the gap 8 of the print head 10 and coil 6 above the ink 2 has an associated capacitance Ch, dependent on the height of the head. This capacitance value Ch is measured in a capacitance bridge 18, against a reference capacitance CR (as shown in Figure 2). A resulting voltage V is employed to adjust the height of the head by a suitable mechanism 20. Capacitance value Ch provides a means of monitoring the height of the head 10 for ensuring optimum deposition and heating. Measurement of the heating current provides a means of controlling the overall heating of the deposited ink, as schematically indicated at 22, since as the ink changes to a solid phase, the impedance of the ink to current flow will change and therefore the heating current will change accordingly. Depending on the precise ink and line characteristics, the resistance or reactance of the ink line may decrease (or increase).

In Figure 2, there is shown a schematic diagram which demonstrates the principle of operation of the inductive fixing means in greater detail. As shown in this Figure, Ink 2 to be cured is deposited on a substrate 4 (which can be flat or curved). The ink 2 to be cured is then scanned over with an induction coil 6, following the printed/deposition features of the ink. The gap 8 between the ink 2 and the coil 6 and the scanning speed are controlled to provide optimum heating. The coil 6 is attached to the deposition head in figure 1 so that it automatically and immediately follows the deposition as the head is moved in direction d so that deposition and curing is done in a single step. Alternatively, the curing step can be isolated from the deposition step and the coil scans the deposited area independently of the deposition head.

The use of an induction coil to impart a localised curing energy to the printed ink track 2 is merely an example embodiment of the invention. In accordance with the invention it is preferable that at least some form of localised cure is employed, in particular in close succession to the deposition step. Preferably, a curing tool is provided which imparts such a curing energy. However, an induction coil is just one such example. Further examples of such curing tools might include a laser for an optically curable ink.

The combination deposition head 10 further includes a plating tool 24 to supply an electroplating solution in a controlled manner to an area of the surface of the substrate 4 on which has been deposited and cured a track of ink 2 in the manner above described. In the embodiment the plating tool is disposed to be applied to the ink track 2 closely subsequent to its cure by the action of the coil 6. The tool includes an electrolyte retaining formation 26, which may for example be an absorptive member impregnated with a suitable plating solution for electroplating a desired conductor. A first electrode 29 makes electrical contact with the solution and supplies an anode current so that the arrangement serves as an anode. Once an ink track 2 has been printed and fixed in the above described manner, the tool 24 is moved into contact with the surface of the printed track so that plating solution makes contact with the surface, for example in the case of a use of an absorptive member, in that a tip of the absorptive member presses onto the track surface. A pair of second Electrodes 28 makes additional contact with the track surface.

The first electrode 29 is connected to a positive pole of an electroplating circuit to provide an anode and the second electrodes 28 are connected to a negative pole of an electroplating circuit to provide a cathode in familiar manner. Thus, in effect, the electrolyte retaining formation 26 serves as an anode and the printed track serves as a cathode. Although printed inks might have relatively low conductivity, the ink is selected to have at least sufficient conductivity that it can serve as a precursor surface by functioning as a cathode as part of an electroplating circuit in this way.

The tool 24 may make progressive contact across printed regions of the substrate to plate continuously on printed tracks. In the embodiment, the tool forms part of a combined deposition head so that if the deposition head is moved in a direction d the plating step automatically and immediately follows the deposition and cure steps, so that deposition, curing and plating are done in a single step process as the combination head is moved. Alternatively, the plating step can be isolated from the deposition step or combined deposition and cure step and the plating tool 24 may scan the deposited track area independently of the rest of the deposition head.

In the illustrated embodiment, paired second electrodes 28 are provided to serve as cathodes. A first electrode leads the plating solution source 26 and a second electrode follows the plating solution source 26 as the tool is drawn across the substrate in direction d. Each electrode is conveniently a flexible electrically conductive blade member which is made of any suitable material, for example suitable metallic conductor such as a copper alloy.

The combination tool may be used to deposit in situ complex and discrete functional structures with properties which substantially approximate to those of the bulk conductor which is electroplated even on difficult conformal substrates. The Direct Write ink track 2 serves merely as a precursor layer, forming a cathode of the electroplating circuit with the electroplating tool, but ultimately playing a negligible role in the bulk properties of the final fabricated structure. Accordingly, as will be familiar for Direct Write inks, it can have relatively low conductivity. It is the electrical currents supplied to the electroplating circuit above described, in conjunction with the speed of travel of the electroplating tool across the surface of the Direct Write ink track 2 on the substrate, that control the amount of conductor which is plated onto the ink track 2 to provide a layer of conductor of a desired thickness. Thus, it is control of the electroplating tool 24, or the electroplating part of the combination tool head 10, that controls the properties of the conductive structure, and ensures that these properties approximate more closely to bulk metal properties.

It is a particular advantage of the tool and method of the invention that the structure need not be immersed in a plating solution. In a preferred embodiment as illustrated, nor need it be immersed in a curing oven or the like. The tool illustrated allows a precursor conductive layer to be deposited and cured, and a substantive layer having substantially bulk metal properties to be plated thereon, by a simple combination tool via a progressive serial and continuous process in situ.

## Claims

1. A method of forming a component of a conductive structure on a substrate, comprising: in a first step applying a surface treatment to said substrate to form a patterned area having at least some electrical conductivity; in a second step electroplating onto the patterned area by means of a tool comprising a first electrode and an electrolyte source for in situ supply of electrolyte, by providing an anode current to the first electrode, causing the patterned area at least in the vicinity of the tool to function as a cathode, and passing electrolyte between said patterned area and said first electrode, thereby to deposit conductive material onto said patterned area
**characterised in that** the steps of applying the surface treatment to the substrate and plating the conductor are performed closely consecutively in a continuous progressive process, so that a pattern of areas of seed conductivity is created on a surface of a substrate and a conductor is then deposited onto a substrate in a continuous manner.

2. The method of claim 1 wherein the first step of applying a surface treatment comprises applying a surface layer material to selected areas of the surface of said substrate defining the patterned area to create a patterned area having at least some electrical conductivity.

3. The method of claim 1 or 2 wherein the surface layer material is a fluid material applied in fluid form to selected areas of the surface and secondarily treated to form a consistent conductive layer.

4. The method of claim 3 wherein the step of secondary treatment is performed closely consecutively to the step of applying the fluid material in a continuous progressive process.

5. The method of claim 3 or 4 wherein the surface layer material is a curable composition, and the first step of the method comprises applying the curable composition to selected areas of the surface and curing the same in situ thereon.

6. The method of any preceding claim wherein the step of depositing conductive material comprises use of a plating tool which comprises electrolyte holding means to hold a locally isolated supply of electrolyte, in which the means to supply an anode current is an electrode in electrical connection with electrolyte carried by the electrolyte holding means, and in which a coating of electrolyte is applied to the substrate by bringing the electrolyte holding means into functional association with the patterned area and completing a plating circuit between electrolyte holding means as anode and patterned area as cathode to plate conductive material thereon.

7. An apparatus for forming a component on a substrate, comprising:
a surface treatment tool adapted to treat the surface of said substrate to form a patterned area having at least some electrical conductivity; and an electroplating tool comprising a first electrode and a current supply for providing an anode current to the first electrode, a means to cause the patterned area at least in the vicinity of the electroplating means to function as a cathode, and an electrolyte source for in situ supply of electrolyte between said patterned area and said first electrode, thereby to deposit conductive material onto said patterned area
**characterised in that** the surface treatment tool and the electroplating tool are so disposed on a common apparatus as to be movable across the substrate surface such that the surface treatment tool and the electroplating tool are brought in use consecutively in close succession into functional contact with the surface.

8. Apparatus according to claim 7 wherein the surface treatment tool comprises a source of a surface layer material to be applied in use to selected areas of the surface of said substrate defining the patterned area to create a patterned area having at least some electrical conductivity.

9. Apparatus according to claim 8 wherein the surface treatment tool comprises a printer including fluid material deposition means for applying a fluid surface layer material to selected areas of the surface of the substrate in use.

10. Apparatus according to claim 9 wherein the printer further comprises fixing means to secondarily treat and fix fluid material deposited on a substrate in situ.

11. Apparatus according to claim 10 wherein the fluid material deposition means are adapted to deliver a curable composition and the printer further comprises curing means to cure a curable composition deposited on a substrate in situ.

12. Apparatus according to one of claims 7 to 11 wherein the electroplating tool is adapted to electroplate conductor onto areas of seed conductivity immediately subsequently to those areas being formed by the surface treatment tool to allow creation of a seed layer and subsequent plating of conductor on the substrate in a continuous manner.

13. Apparatus according to one of claims 7 to 12 wherein the electroplating tool includes a means to hold a locally isolated supply of electrolyte in which electrolyte can be carried, an electrode in electrical connection with electrolyte carried by the electrolyte source, and a means to bring the electrolyte source into selective functional association with the patterned area.

14. Apparatus according to claim 13 wherein the means to cause the patterned area at least in the vicinity of the tool to function as a cathode is a second electrode, electrically insulated from the first electrode and spaced from the electrolyte source, the electroplating means includes means to bring the second electrode into selective contact with the patterned area.

15. Apparatus according to one of claims 13 or 14 wherein the means to cause the patterned area at least in the vicinity of the tool to function as a cathode comprises a scanning electron beam source to ionise the patterned area in the vicinity of the beam and create an opposite polarity to the polarity of the first electrode.

16. Apparatus according to any one of claims 7 to 15 wherein the surface treatment tool comprises a printer including fluid surface layer material deposition means and fluid surface layer material fixing means, and the deposition means, fixing means and electroplating tool are so disposed on a common apparatus as to be movable across the substrate surface such that the surface treatment tool and the electroplating tool are brought in use consecutively in close succession into functional contact with the surface.

## Patentansprüche

1. Verfahren zum Ausbilden einer Komponente einer leitenden Struktur auf einem Substrat, umfassend: in einem ersten Schritt das Anwenden einer Oberflächenbehandlung auf das Substrat zum Ausbilden eines strukturierten Bereichs mit mindestens etwas elektrischer Leitfähigkeit; in einem zweiten Schritt das Elektroplattieren auf den strukturierten Bereich mit Hilfe eines Werkzeugs, umfassend eine erste Elektrode und eine Elektrolytquelle für die in situ-Zufuhr von Elektrolyt durch Bereitstellen eines Anodenstroms zu der ersten Elektrode, das Bewirken, dass der strukturierte Bereich mindestens in der Nähe des Werkzeugs als eine Kathode fungiert und das Schicken von Elektrolyt zwischen dem strukturierten Bereich und der ersten Elektrode, wodurch leitendes Material auf dem strukturierten Bereich abgeschieden wird,
**dadurch gekennzeichnet, dass** die Schritte des Anwendens der Oberflächenbehandlung auf das Substrat und des Plattierens des Leiters eng nacheinander in einem kontinuierlichen progressiven Prozess durchgeführt werden, so dass eine Struktur von Bereichen mit Keimleitfähigkeit auf einer Oberfläche eines Substrats erzeugt wird und ein Leiter dann auf einem Substrat auf kontinuierliche Weise abgeschieden wird.

2. Verfahren nach Anspruch 1, wobei der erste Schritt des Anwendens einer Oberflächenbehandlung das Aufbringen eines Oberflächenschichtmaterials auf ausgewählte Bereiche der Oberfläche des Substrats umfasst, den strukturierten Bereich definierend, um einen strukturierten Bereich mit mindestens etwas elektrischer Leitfähigkeit herzustellen.

3. Verfahren nach Anspruch 1 oder 2, wobei das Oberflächenschichtmaterial ein Fluidmaterial ist, das in Fluidform auf ausgewählte Bereiche der Oberfläche aufgebracht und sekundär behandelt wird, um eine konsistente leitende Schicht auszubilden.

4. Verfahren nach Anspruch 3, wobei der Schritt der sekundären Behandlung kurz nach dem Schritt des Aufbringens des Fluidmaterials in einem kontinuierlichen progressiven Prozess ausgeführt wird.

5. Verfahren nach Anspruch 3 oder 4, wobei das Oberflächenschichtmaterial eine härtbare Zusammensetzung ist und der erste Schritt des Verfahrens das Aufbringen der härtbaren Zusammensetzung auf ausgewählte Bereiche der Oberfläche und das Härten selbiger in situ darauf umfasst.

6. Verfahren nach einem vorhergehenden Anspruch, wobei der Schritt des Abscheidens von leitendem Material die Verwendung eines Plattierwerkzeugs umfasst, das Elektrolythaltemittel zum Halten einer lokal isolierten Zufuhr von Elektrolyt umfasst, bei dem das Mittel zum Zuführen eines Anodenstroms eine Elektrode in elektrischer Verbindung mit einem von dem Elektrolythaltemittel geführten Elektrolyt ist und bei dem eine Beschichtung aus Elektrolyt auf das Substrat aufgebracht wird durch Bringen des Elektrolythaltemittels in funktionelle Assoziation mit dem strukturierten Bereich und Vervollständigen eines Plattierungskreises zwischen dem Elektrolythaltemittel als Anode und strukturiertem Bereich als Kathode, um leitendes Material darauf zu plattieren.

7. Vorrichtung zum Ausbilden einer Komponente auf einem Substrat, umfassend: ein Oberflächenbehandlungswerkzeug, das ausgelegt ist zum Behandeln der Oberfläche des Substrats zum Ausbilden eines strukturierten Bereichs mit mindestens etwas elektrischer Leitfähigkeit; und ein Elektroplattierungswerkzeug, umfassend eine erste Elektrode und eine Stromzufuhr zum Liefern eines Anodenstroms zu der ersten Elektrode, ein Mittel, um zu bewirken, dass der strukturierte Bereich mindestens in der Nähe des Elektroplattierungsmittels als eine Kathode fungiert, und eine Elektrolytquelle für die in situ-Zufuhr von Elektrolyt zwischen dem strukturierten Bereich und der ersten Elektrode, um dadurch leitendes Material auf dem strukturierten Bereich abzuscheiden,
**dadurch gekennzeichnet, dass** das Oberflächenbehandlungswerkzeug und das Elektroplattierungswerkzeug so auf einer gemeinsamen Vorrichtung angeordnet sind, dass sie über die Substratoberfläche bewegt werden können, so dass das Oberflächenbehandlungswerkzeug und das Elektroplattierungswerkzeug bei Gebrauch nacheinander in enger Aufeinanderfolge in funktionellen Kontakt mit der Oberfläche gebracht werden.

8. Vorrichtung nach Anspruch 7, wobei das Oberflächenbehandlungswerkzeug eine Quelle eines Oberflächenschichtmaterials umfasst, das bei Gebrauch auf ausgewählte Bereiche der Oberfläche des Substrats aufgebracht werden soll, den strukturierten Bereich definierend, um einen strukturierten Bereich mit mindestens etwas elektrischer Leitfähigkeit zu erzeugen.

9. Vorrichtung nach Anspruch 8, wobei das Oberflächenbehandlungswerkzeug einen Drucker mit Fluidmaterialabscheidungsmitteln zum Aufbringen eines Fluidoberflächenschichtmaterials auf ausgewählte Bereiche der Oberfläche des Substrats bei Gebrauch umfasst.

10. Vorrichtung nach Anspruch 9, wobei der Drucker weiterhin Fixiermittel umfasst zum sekundären Behandeln und Fixieren von auf einem Substrat in situ abgeschiedenem Fluidmaterial.

11. Vorrichtung nach Anspruch 10, wobei die Fluidmaterialabscheidungsmittel ausgelegt sind zum Liefern einer härtbaren Zusammensetzung und der Drucker weiterhin Härtungsmittel zum Härten einer auf einem Substrat in situ abgeschiedenen härtbaren Zusammensetzung umfasst.

12. Vorrichtung nach einem der Ansprüche 7 bis 11, wobei das Elektroplattierungswerkzeug ausgelegt ist zum Elektroplattieren eines Leiters auf Bereiche von Keimleitfähigkeit, unmittelbar nachdem jene Bereiche durch das Oberflächenbehandlungswerkzeug ausgebildet worden sind, zum Gestatten der Herstellung einer Keimschicht und nachfolgendes Plattieren des Leiters auf dem Substrat auf kontinuierliche Weise.

13. Vorrichtung nach einem der Ansprüche 7 bis 12, wobei das Elektroplattierungswerkzeug ein Mittel enthält zum Halten einer lokal isolierten Zufuhr von Elektrolyt, in der Elektrolyt geführt werden kann, eine Elektrode in elektrischer Verbindung mit von der Elektrolytquelle geführtem Elektrolyt und ein Mittel zum Bringen der Elektrolytquelle in selektive funktionelle Assoziation mit dem strukturierten Bereich.

14. Vorrichtung nach Anspruch 13, wobei das Mittel zum Bewirken, dass der strukturierte Bereich mindestens in der Nähe des Werkzeugs als eine Kathode fungiert, eine zweite Elektrode ist, elektrisch von der ersten Elektrode isoliert und von der Elektrolytquelle beabstandet, das Elektroplattierungsmittel Mittel enthält zum Bringen der zweiten Elektrode in selektiven Kontakt mit dem strukturierten Bereich.

15. Vorrichtung nach einem der Ansprüche 13 oder 14, wobei das Mittel zum Bewirken, dass der strukturierte Bereich mindestens in der Nähe des Werkzeugs als eine Kathode fungiert, eine Rasterelektronenstrahlquelle umfasst zum Ionisieren des strukturierten Bereichs in der Nähe des Strahls und Erzeugen einer entgegengesetzten Polarität zu der Polarität der ersten Elektrode.

16. Vorrichtung nach einem der Ansprüche 7 bis 15, wobei das Oberflächenbehandlungswerkzeug einen Drucker mit Fluidoberflächenschichtmaterialabscheidungsmitteln und Fluidoberflächenschichtmaterialfixiermitteln umfasst und die Abscheidungsmittel, die Fixiermittel und das Elektroplattierungswerkzeug so auf einer gemeinsamen Vorrichtung angeordnet sind, dass sie über die Substratoberfläche bewegt werden können, so dass das Oberflächenbehandlungswerkzeug und das Elektroplattierungswerkzeug bei Gebrauch nacheinander in enger Aufeinanderfolge in funktionellen Kontakt mit der Oberfläche gebracht werden.

## Revendications

1. Procédé de formation d'un composant d'une structure conductrice sur un substrat, comprenant :
dans une première étape, l'application d'un traitement de surface audit substrat pour former une zone à motifs qui présente au moins une certaine conductivité électrique ; dans une deuxième étape, l'électrodéposition sur la zone à motifs au moyen d'un outil comprenant une première électrode et une source d'électrolyte pour la fourniture d'électrolyte sur site, en délivrant un courant d'anode à la première électrode, ce qui a pour effet que la zone à motifs fonctionne comme une cathode au moins à proximité de 1"outil, et passage de l'électrolyte entre ladite zone à motifs et ladite première électrode pour déposer ainsi du matériau conducteur sur ladite zone à motifs,
**caractérisé en ce que** les étapes d'application du traitement de surface au substrat et de déposition du conducteur sont exécutées consécutivement proches l'une de l'autre dans un processus progressif continu, de manière à créer un motif de zones à conductivité inoculée sur une surface d'un substrat et un conducteur est ensuite déposé sur un substrat de manière continue.

2. Procédé selon la revendication 1, selon lequel la première étape d'application d'un traitement de surface comprend l'application d'un matériau de couche de surface sur des zones sélectionnées de la surface dudit substrat définissant la zone à motifs afin de créer une zone à motifs qui présente au moins une certaine conductivité électrique.

3. Procédé selon la revendication 1 ou 2, selon lequel le matériau de couche de surface est un matériau fluide appliqué sous forme fluide sur des zones sélectionnées de la surface et ensuite traité pour former une couche conductrice cohérente.

4. Procédé selon la revendication 3, selon lequel l'étape de traitement secondaire est exécutée consécutivement proche de l'étape d'application du matériau fluide dans un processus progressif continu.

5. Procédé selon la revendication 3 ou 4, selon lequel le matériau de couche de surface est une composition durcissable par cuisson et la première étape du procédé comprend l'application de la composition durcissable par cuisson sur des zones sélectionnées de la surface et le durcissement par cuisson de celle-ci sur site sur la surface.

6. Procédé selon l'une quelconque des revendications précédentes, selon lequel l'étape de déposition de matériau conducteur comprend l'utilisation d'un outil de déposition qui comprend des moyens de maintien d'électrolyte pour maintenir une source localement isolée d'électrolyte, dans lequel les moyens de fourniture d'un courant d'anode sont une électrode en liaison électrique avec l'électrolyte transporté par les moyens de maintien d'électrolyte, et dans lequel un revêtement d'électrolyte est appliqué sur le substrat en amenant les moyens de maintien d'électrolyte en association fonctionnelle avec la zone à motifs et en terminant un circuit déposé entre les moyens de maintien d'électrolyte faisant office d'anode et la zone à motifs faisant office de cathode pour déposer du matériau conducteur sur celle-ci.

7. Appareil pour former un composant sur un substrat, comprenant : un outil de traitement de surface adapté pour traiter la surface dudit substrat pour former une zone à motifs qui présente au moins une certaine conductivité électrique ; et un outil d'électrodéposition comprenant une première électrode et une source de courant pour délivrer un courant d'anode à la première électrode, des moyens pour faire fonctionner la zone à motifs comme une cathode au moins à proximité des moyens d'électrodéposition, et une source d'électrolyte pour la fourniture d'électrolyte sur site entre ladite zone à motifs et ladite première électrode, pour déposer ainsi du matériau conducteur sur ladite zone à motifs,
**caractérisé en ce que** l'outil de traitement de surface et l'outil d'électrodéposition sont disposés sur un appareil commun de manière à pouvoir être déplacés en travers de la surface du substrat de telle sorte que l'outil de traitement de surface et l'outil d'électrodéposition, lors de l'utilisation, sont amenés consécutivement dans une succession proche en contact fonctionnel avec la surface.

8. Appareil selon la revendication 7, dans lequel l'outil de traitement de surface comprend une source d'un matériau de couche de surface à appliquer, lors de l'utilisation, sur des zones sélectionnées de la surface dudit substrat définissant la zone à motifs afin de créer une zone à motifs qui présente au moins une certaine conductivité électrique.

9. Appareil selon la revendication 8, dans lequel l'outil de traitement de surface comprend une imprimante incluant des moyens de déposition de matériau fluide pour appliquer, lors de l'utilisation, un matériau de couche de surface fluide sur des zones sélectionnées de la surface du substrat.

10. Appareil selon la revendication 9, dans lequel l'imprimante comprend en outre des moyens de fixation pour effectuer un traitement secondaire et fixer le matériau fluide déposé sur site sur un substrat.

11. Appareil selon la revendication 10, dans lequel les moyens de déposition de matériau fluide sont adaptés pour délivrer une composition durcissable par cuisson et l'imprimante comprend en outre des moyens de durcissement par cuisson pour durcir par cuisson une composition durcissable par cuisson déposée sur site sur un substrat.

12. Appareil selon l'une des revendications 7 à 11, dans lequel l'outil d'électrodéposition est adapté pour effectuer l'électrodéposition d'un conducteur sur des zones à conductivité inoculée immédiatement après la formation de ces zones par l'outil de traitement de surface afin de permettre la création d'une couche d'inoculation et ensuite la déposition d'un conducteur sur le substrat d'une manière continue.

13. Appareil selon l'une des revendications 7 à 12, dans lequel l'outil d'électrodéposition comprend des moyens pour maintenir une source localement isolée d'électrolyte dans laquelle peut être transporté l'électrolyte, une électrode en liaison électrique avec l'électrolyte transporté par la source d'électrolyte, et des moyens pour amener la source d'électrolyte en association fonctionnelle sélective avec la zone à motifs.

14. Appareil selon la revendication 13, dans lequel les moyens pour faire fonctionner la zone à motifs comme une cathode au moins à proximité de l'outil sont une deuxième électrode, isolée électriquement de la première électrode et espacée de la source d'électrolyte, les moyens d'électrodéposition incluant des moyens pour amener la deuxième électrode en contact sélectif avec la zone à motifs.

15. Appareil selon l'une des revendications 13 ou 14, dans lequel les moyens pour faire fonctionner la zone à motifs comme une cathode au moins à proximité de l'outil comprennent une source de faisceau d'électrons de balayage pour ioniser la zone à motifs à proximité du faisceau et créer une polarité opposée à la polarité de la première électrode.

16. Appareil selon l'une quelconque des revendications 7 à 15, dans lequel l'outil de traitement de surface comprend une imprimante incluant des moyens de déposition de matériau de couche de surface fluide et des moyens de fixation de matériau de couche de surface fluide, et les moyens de déposition, les moyens de fixation et l'outil d'électrodéposition sont disposés sur un appareil commun de manière à pouvoir être déplacés en travers de la surface du substrat de telle sorte que l'outil de traitement de surface et l'outil d'électrodéposition, lors de l'utilisation, sont amenés consécutivement dans une succession proche en contact fonctionnel avec la surface.
